# EUROPEAN PATENT APPLICATION

(11) **EP 2 637 031 A1**
(43) Date of publication of application: **11.09.2013**
(21) Application number: 11837906.4
(22) Date of filing: 26.10.2011
(51) Int. Cl.: G01R 31/04, H01R 13/64

(54) **LED LIGHTING DEVICE AND CABLE CONNECTION DETECTION DEVICE**

(30) Priority: 02.11.2010 JP 2010245923
(71) Applicant: Funai Electric Co., Ltd., Nakagaito Daito-shi Osaka 574-0013 (JP)
(72) Inventor: TSUJII Takayuki, Daito-shi Osaka 574-0013 (JP)
(74) Representative: Grünecker, Kinkeldey, Stockmair & Schwanhäusser
(86) International application number: PCT/JP2011/074625
(87) International publication number: WO 2012/060256

(57) **Abstract**

[Problem] To address the problem of reliably detecting cable connection errors such as a reverse insertion or an oblique insertion of a cable.

[Solution] When an LED board B1 and an LED driver circuit board B2 are connected by an FFC 60, a voltage dividing resistor having resistors 71a, 71b and mounted on the LED board B1 is provided, a connection detection section is connected to one end of the voltage dividing resistor via a first transmission line 73 of the FFC 60, connected to another end of the voltage dividing resistor via a transmission line 75 of the FFC 60, and connected to the dividing point of the voltage dividing resistor via a third transmission line 74 of the FFC 60, wherein at least one of the following compositions are applied: (1) the third transmission line 74 is configured not to pass through a center of the FFC 60, and (2) the resistance values of the resistor 71a and the resistor 71 b are made to be different. Then, a control section 10 is configured to detect the connection state of the FFC 60 based on a voltage of the dividing point, which is detected via the third transmission line 74 by supplying power to a loop circuit composed of the first transmission line 73, the voltage dividing resistor, and the second transmission line 75.

## Description

### TECHNICAL FIELD

The present invention relates to an LED (Light-Emitting diode) lighting device in which an LED board and an LED driver board are connected by an FFC (Flexible Flat Cable), and a cable connection detection device in which a first board and a second board are electrically connected by the FFC (Flexible Flat Cable).

### BACKGROUND ART

In a product having a connection by a cable such as the FFC, cable connection errors can be occurred in an assembling process. The following technologies are disclosed for detecting the cable connection errors.

Japanese Patent Application Publication 2008-304363 discloses a cable connection detection device in which a loop circuit is formed from a connector to attach one terminal of an FFC and back to the one terminal via another connector to attach another terminal.

Japanese Patent Application Publication S64-2271 discloses a cable connection monitoring circuit that has a cable formed by aligning plural transmission lines in parallel, wherein a resistor (supposed as a resistor A) is connected to one end of one of the transmission lines and another end of the resistor A is connected to the ground, another end of the same transmission line is connected to another resistor (supposed as a resistor B) and another end of the resistor B is connected to a predetermined power supply voltage.

Japanese Utility Model Patent Registration 3156000 discloses an example of an LED lighting device in which plural LEDs are connected in series to form an LED bar and plural LED bars are connected in parallel to form the LED lighting device.

### PRIOR ART DOCUMENTS

### [Patent Documents]

[Patent Document 1] Japanese Patent Application Publication 2008-304363
[Patent Document 2] Japanese Patent Application Publication 564-2271
[Patent Document 3] Japanese Utility Model Patent Registration 3156000

### DISCLOSURE OF THE INVENTION

### [Problems to be Solved by the Invention]

On the above described technologies, there is no consideration about cable connection errors such as a reverse insertion and an oblique insertion of the cable.
After considering the above, the present invention has an aim to provide an LED lighting device and a cable connection detection device to detect the cable connection errors such as the reverse insertion and the oblique insertion of the cable more reliably.

### [Means for Solving the Problem]

One aspect of the present invention provides an LED (Light-Emitting diode) lighting device in which an LED board that mounts LEDs and an LED driver board that forms an LED driver circuit to turn on the LEDs are connected by an FFC (Flexible Flat Cable), comprising:
a voltage dividing resistor that has a first resistor and a second resistor and mounted on the LED board, and
a connection detection section that is connected to one end of the voltage dividing resistor via a first transmission line of the FFC, connected to another end of the voltage dividing resistor via a second transmission line of the FFC, and connected to a dividing point of the voltage dividing resistor via a third transmission line of the FFC, supplies power to a loop circuit composed of the first transmission line, the voltage dividing resistor and the second transmission line, and detects a connection state of the FFC based on a voltage of the dividing point detected via the third transmission line, wherein
at least one of the following compositions are applied: (1) the third transmission line of the FFC is configured not to pass through a center of the FFC, and (2) the resistance values of the first resistor and the second resistor are made to be different.
Another aspect of the present invention provides a cable connection detection device in which a first board and a second board are electrically connected by an FFC (Flexible Flat Cable), comprising:
   a voltage dividing resistor that has a first resistor and a second resistor and mounted on the first board,
   a connection detection section that is connected to one end of the voltage dividing resistor via a first transmission line of the FFC, connected to another end of the voltage dividing resistor via a second transmission line of the FFC, and connected to a dividing point of the voltage dividing resistor via a third transmission line of the FFC, supplies power to a loop circuit that is composed of the first transmission line, the voltage dividing resistor and the second transmission line, and detects a connection state of the FFC based on a voltage of the dividing point detected via the third transmission line, wherein
   at least one of the following compositions are applied: (1) the third transmission line of the FFC is configured not to pass through a center of the FFC, and (2) the resistance values of the first resistor and the second resistor are made to be different.

### [Effects of the Invention]

As explained above, by using the present invention, the LED lighting device to detect an abnormal connection such as the reverse insertion and the oblique insertion of the cable more reliably can be provided.

According to an alternative second aspect, the abnormal connection of the FFC can be more reliably detected.

According to an alternative third aspect, usability, workability, maintainability, or the like can be improved by notifying a connection state of the FFC.

According to an alternative fourth aspect, the connection state of the FFC can be more correctly detected.

According to an alternative fifth aspect, accuracy to detect the connection state of the FFC can be improved and other effects such as cost reduction can be achieved.

According to an alternative sixth aspect, the abnormal connection of the FFC can be detected reliably even when the FFC 60 is obliquely inserted causing the abnormal connection in certain parts while other parts are normally connected.

According to an alternative seventh aspect, productivity can be improved in respect to workability, yield rate, production cost and other aspects

According to an alternative eighth aspect, a liquid crystal display devise capable of detecting the abnormal connection such as the reverse insertion and the oblique insertion of the FFC can be provided.

According to another ninth aspect, a cable connection detection devise capable of detecting the abnormal connection such as the reverse insertion and the oblique insertion of the FFC can be provided.

### BRIEF DESCRIPTION OF THE DRAWINGS

Fig. 1 is an exemplary illustration of a block diagram schematically showing an electrical structure of a liquid crystal display device.
Fig. 2 is an exemplary illustration showing a connection between an LED board and an LED driver board.
Fig. 3 is exemplary illustrations showing abnormal connections of an FFC.
Fig. 4 is an exemplary illustration showing a structure of an abnormal connection detection circuit to detect an abnormal connection of the FFC.
Fig. 5 is exemplary illustrations showing an alignment of transmission lines.
Fig. 6 is an exemplary illustration of a flow chart showing an abnormal connection detection process.
Fig. 7 is an exemplary illustration of a block diagram showing a structure of an inspection system concerning a variation example.
Fig. 8 is an exemplary illustration of a flow chart showing an abnormal connection detection process.

### BEST MODES FOR CARRYING OUT THE INVENTION

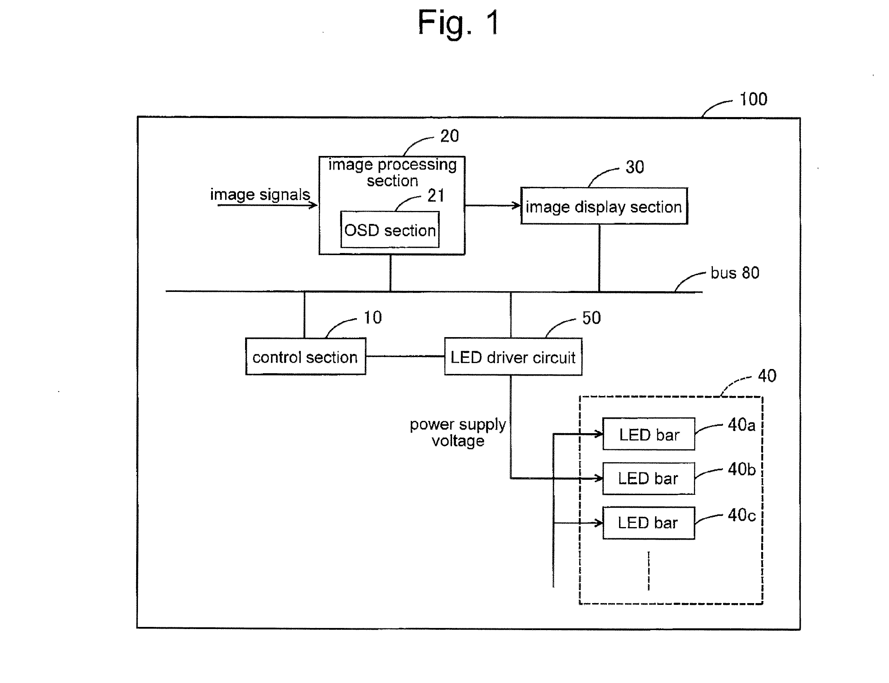

Hereinafter, embodiments of the present invention will be explained with reference to Figs. 1 to 8.
In an LED lighting device, an LED board B1 mounting LEDs is connected to an LED driver board B2 that forms an LED driver circuit 50 to turn on the LEDs by an FFC 60 having plural transmission lines. Consequently, the LED driver circuit 50 turns on the LEDs via the FFC 60. The LED lighting device is configured to have a voltage dividing resistor and a connection detection section. The voltage dividing resistor is composed of a first resistor 71 a and a second resistor 71 b that are mounted on the LED board B1. The connection detection section is connected to one end of the voltage dividing resistor via a first transmission line 73 of the FFC 60, connected to another end of the voltage dividing resistor via the second transmission line 75 of the FFC 60, and connected to the dividing point of the voltage dividing resistor via a third transmission line 74 of the FFC 60.

In the above mentioned structure, the connection detection section supplies power to a loop circuit that is composed of the first transmission line 73 of the FFC 60, the voltage dividing resistor and the second transmission line 75, and monitors the voltage of the dividing point via the third transmission line 74. Then, the connection detection section detects a connection state of the FFC 60 based on the voltage of the dividing point. For example, the connection detection section judges whether or not the voltage of the dividing point is more than a predetermined value, whether or not the predetermined value, or whether or not within a predetermined range. Then, the voltage of the dividing point is judged to be a voltage when the FFC 60 is abnormally connected or to be a voltage when the FFC 60 is normally connected, and then a predetermined process is executed or the predetermined process is not executed based on a result of the judgment.

In the above mentioned structure, the third transmission line 74 of the FFC 60 can be configured not to pass through approximately center of the FFC 60 in order to make the judgment accurately based on the voltage of the dividing point.
By using the above mentioned structure, if the FFC 60 is reversely inserted, for example, the voltage of the dividing point cannot be detected because the connection detection section is connected to the dividing point without passing through the third transmission line 74. Therefore, the connection detection section detects abnormal voltage, and thus the reverse insertion (abnormal connection) of the FFC 60 can be detected.
For example, if the FFC 60 is obliquely inserted and at least one channel of the first to third transmission lines 74 in the connection detection section is not properly connected, the voltage is not properly generated at the dividing point or the voltage of the dividing point cannot be detected. Therefore, the connection detection section detects abnormal voltage, and thus the oblique insertion (abnormal connection) of the FFC 60 can be detected.

In the above mentioned structure, resistance values of the first resistor 71a and the second resistor 71b can be made to be different in order to make the judgment accurately based on the voltage of the dividing point.
By using the above mentioned structure, if the FFC 60 is reversely inserted, for example, the detected voltage is different from the voltage when the FFC 60 is correctly connected. Therefore, the connection detection section detects abnormal voltage, and thus the reverse insertion (abnormal connection) of the FFC 60 can be detected.
For example, if the FFC 60 is obliquely inserted and at least one channel of the first to third transmission lines 74 in the connection detection section is not properly connected, the voltage is not properly generated at the dividing point or the voltage of the dividing point cannot be detected. Therefore, the connection detection section detects abnormal voltage, and thus the oblique insertion (abnormal connection) of the FFC 60 can be detected.

Note that the reverse insertion or the oblique insertion of the FFC 60 can be detected if at least one of the following compositions are applied: (1) the third transmission line 74 of the FFC 60 is configured not to pass through a center of the FFC 60, and (2) the resistance values of the first resistor 71a and the second resistor 7 1 b are made to be different. Of course, the abnormal connection of the FFC 60 is not limited to the reverse insertion and the oblique insertion. The abnormal connection can be also caused by using different kind of cable having different number of transmission lines or caused by electrical disconnection of the first to third transmission lines 74 of the FFC 60.

In an alternative aspect of the present invention, the first transmission line 73 and the second transmission line 75 are located asymmetrically with respect to a center of the FFC 60. In other words, by locating the first transmission line 73 and the second transmission line 75 asymmetrically with respect to the center of the FFC 60, if the FFC 60 is reversely inserted, for example, the loop circuit is not realized and a proper voltage is not generated at the dividing point. Therefore, the connection detection section detects an abnormal voltage, and thus the reverse insertion (abnormal connection) of the FFC 60 can be detected more reliably. Of course, if the FFC 60 is obliquely inserted, the connection detection section can also detect the oblique insertion abnormal connection) of the FFC 60 more reliably.

In an alternative aspect of the present invention, the connection detection section has a notice section that notifies the connection state of the FFC 60. In other words, the connection state of the FFC 60 can be notified by the notice section as a process to be carried out when the connection state of the FFC 60 is detected. Therefore, the connection state of the FFC 60 can be notified to those who concerning the LED lighting device such as users of the LED lighting devise, workers assembling the LED lighting devise, or workers repairing and maintaining the LED lighting devise. Consequently, usability, workability, maintainability, or the like can be improved.

In an alternative aspect of the present invention, the connection detection section detects the FFC 60 is normally connected if the voltage of the dividing point is within a predetermined range while the connection detection section detects the FFC 60 is abnormally connected if the voltage of the dividing point is out of the predetermined range. By using the above mentioned structure, the connection state can be judged with higher accuracy compared to the case where only one threshold value is used to judge the connection is normal or abnormal depending on whether the voltage is over or under the threshold value. Therefore, the connection state of the FFC 60 can be more accurately detected.

In an alternative aspect of the present invention, the connection detection section has a window comparator circuit 72. The connection of the FFC 60 is detected to be normal if the window comparator circuit 72 judges the voltage of the dividing point is within a predetermined range, while the connection of the FFC is detected to be abnormal if the window comparator circuit 72 judges the voltage of the dividing point is out of the predetermined range. By using the above mentioned structure, whether or not the voltage of the dividing point is within the predetermined range can be easily judged by a simple circuit structure. Consequently, accuracy to detect the connection state of the FFC 60 can be improved and other effects such as cost reduction can be achieved.

In an alternative aspect of the present invention, when plural transmission lines of the FFC 60 are divided into three approximately equal parts of two end parts and a middle part, the first transmission line 73, the second transmission line 75 and the third transmission line 74 are configured to be included one by one in each part. By using the above mentioned structure, the first to third transmission lines 74 are aligned all around the FFC 60 to enable to detect the abnormal connection of the FFC 60 reliably even when the FFC 60 is obliquely inserted causing the abnormal connection in certain parts while other parts are normally connected.

In an alternative aspect of the present invention, an LED bar is formed by connecting plural LEDs in series, an LED circuit is formed by connecting plural LED bars in parallel, the LED circuit is mounted on the LED board B1, and the LED driver circuit 50 supplies a predetermined power to respective LED bars via the FFC 60. In components such as the LED bar, if connection errors are occurred in one of the transmission lines, the plural LEDs may be broken. However, by using the above mentioned structure, the abnormal connection of the FFC 60 can be detected reliably preventing the components from being broken caused by the abnormal connection. Therefore, productivity can be improved in respect to workability, yield rate, production cost and other aspects.

In an alternative and specific aspect of the present invention, the LED lighting device is a back light device to emit light from a back side of a liquid crystal panel of the liquid crystal display devise or a side light device to emit light from a lateral side of the liquid crystal panel of the liquid crystal display devise, an LED bar is formed by connecting plural LEDs in series, an LED circuit is formed by connecting plural LED bars in parallel, the LED circuit is mounted on the LED board B1, the LED driver circuit 50 supplies a predetermined power to respective LED bars via the FFC 60, the connection detection section has a window comparator circuit 72, the connection of the FFC 60 is detected to be normal if the window comparator circuit 72 judges the voltage of the dividing point is within a predetermined range, while the connection is detected to be abnormal if the window comparator circuit 72 judges the voltage of the dividing point is out of the predetermined range, when plural transmission lines are divided into three approximately equal parts of two end parts and a middle part, the first transmission line 73 is located on one of the end parts, the second transmission line 75 is located on another end part, and the third transmission line 74 is located on approximately center. Namely, it is sure that the above explained functions and effects can be achieved in the liquid crystal display devise using the above described LED lighting device.

In another aspect of the present invention, in a cable connection detection device having a first board (B1), a second board (B2), and an FFC 60 having plurality of transmission lines to connect the first board (B1) and the second board (B2), comprising a dividing resistor that is composed of a first resistors 71a and a second resistor 71b and mounted on the first board (B1), and a connection detection section that is connected to one end of the voltage dividing resistor via the first transmission line 73 of the FFC 60, connected to another end of the voltage dividing resistor via the second transmission line 75 of the FFC 60, connected to a dividing point of the voltage dividing resistor via the third transmission line 74 of the FFC 60, supplies power to a loop circuit that is composed of the first transmission line 73 of the FFC 60, the voltage dividing resistor and the second transmission line 75, and detects a connection state of the FFC based on a voltage of the dividing point, wherein at least one of the following compositions are applied: (1) the third transmission line 74 of the FFC 60 is configured not to pass through a center of the FFC 60, and (2) the resistance values of the first resistor 71 a and the second resistor 71b are made to be different. Namely, by applying the present invention, the abnormal connection of the FFC 60 can be detected if the FFC 60 connects two boards for transmitting various power supply voltage and electrical signals, without being limited to the FFC 60 that connects the LED board B1 and the LED driver board B2.

### (1) Structure of the liquid crystal display device:

The structure of the liquid crystal display device will be explained with reference to Fig. 1. Although the invention will be explained using an example of applying the invention to the liquid crystal display device in the present embodiment, the invention can be also achieved as a stand-alone LED lighting device used for a light source of a liquid crystal that forms a part of the liquid crystal display device. Furthermore, in addition to the LED lighting device, the invention can be also applied to various electric devises and electronic devices that have a connection using the FFC. In that sense, the invention can be also achieved as a cable connection detection device.

Fig. 1 is a block diagram schematically showing an electrical structure of a liquid crystal display device. In the figure, a liquid crystal display device 100 has a control section 10 that controls whole the liquid crystal display device 100, an image processing section 20 that applies various image processing to image signals input to the liquid crystal display device 100, an image display section 30 that displays images on a screen based on the image signals, LED bars 40a, 40b, 40c, --- (hereafter, written as LED bars 40 except when to write individually is needed) on which plural LEDs are aligned in series, and an LED driver circuit 50 that generates power supply voltage to turn on the LED bars 40 and controls to turn on/off the LED bars 40. The above components 10 to 30 are connected via a bus 80 (e.g. 12C bus), for example, to communicate with each other.

The control section 10 can be composed of a CPU that plays a central role in a processing, a ROM that records control programs, and a RAM that is used as a work area where programs are extracted or data are temporarily saved, for example. The CPU extracts the control programs recorded in the ROM on the RAM and executes the extracted programs to control the liquid crystal display device 100. Of course, the control section 10 can be achieved as a circuit. For example, the control section 10 can be achieved as an integrated circuit such as an ASIC (Application Specific Integrated Circuit).

Note that the control section 10, together with the later mentioned abnormal connection detection circuit 70, is corresponding to the connection detection section in the present embodiment by executing the later mentioned abnormal connection detection process. However, the structure is not limited to this structure. For example, another section can be provided separate from the control section 10 to control the later mentioned abnormal connection detection process. In the present embodiment, the control section 10 achieves later mentioned abnormal connection detection process as software, but it can be also achieved as a circuit or as a combination of the software and the circuit.

The image processing section 20 outputs variously processed image signals to the image display section 30. A variety of image signals can be input to the image processing section 20. For example, image signals extracted from a television broadcast signal and image signals created based on the data read from a recording media such as a DVD (Digital Versatile Disk) or HD (Hard Disk) can be input. A tuner required for receiving the television broadcast signal and a reader required for reading data from the recording media (e.g. DVD drive and HD drive) can be built in the liquid crystal display device 100 or can be externally attached.

The image processing section 20 also has an OSD section 21 to superimpose OSD signals on the image signals. A variety of images and letters can be added on the images displayed on the image display section 30 by superimposing a certain image on the image signals as the OSD signal or superimposing a certain message on the image signals as the OSD signal.

The image display section 30 is composed of a liquid crystal panel and a driver circuit of the liquid crystal panel, for example. The images are displayed on the screen by driving liquid crystals of the liquid crystal panel based on the image signal input from the image processing section 20. At that time, the LED bars 40 become a back light device to emit light from a back side of the liquid crystal panel or a side light device to emit light from a lateral side of the liquid crystal panel. Note that the LED bars 40 are corresponding to the LED circuit in the present embodiment.

The LED driver circuit 50 is supplied power from a not illustrated power circuit. Based on the power supply voltage supplied from the power circuit, the LED driver 50 generates power supply voltage to turn on the LED bars 40. The LED driver circuit 50 supplies power to each LED bar 40a, 40b, 40c, --- by using individual channels (transmission lines). Therefore, the LED bar 40a, 40b, 40c, --- can be selectively turned on or off by selectively turning on or off switching elements provided on a side of the LED driver circuit 50.

In the present embodiment, among the above explained components, the LED bars 40 are mounted on the LED board B1 (first board), the LED driver circuit 50 is mounted on the LED driver circuit board B2 (second board), and the control section 10 and the image processing section 20 are mounted on a not illustrated control board. Note that various structures can be adopted as long as the board mounting the LED bars 40 is different from the board mounting the LED driver circuit. The structure can be variously changed. For example, the LED driver circuit 50, the control section 10, and the image processing section 20 can be mounted on one board (e.g. on the LED driver circuit 50).

### (2) Connection between the LED board and the LED driver board

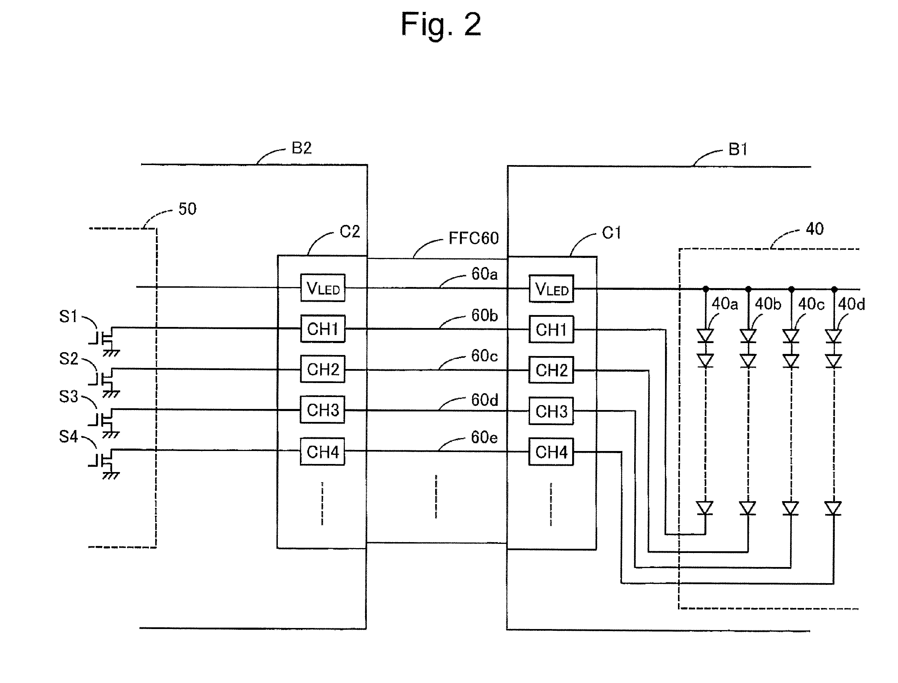

Fig. 2 shows an example of a connection between the LED board B1 and the LED driver circuit board B2. As shown in the figure, the LED board B1 and the LED driver circuit board B2 are connected by an FFC (Flexible Flat Cable) 60. A connector C1 and a connector C2 are provided respectively on the LED board B1 and the LED driver circuit board B2 in order to connect them to the FFC 60. The connector C2 has terminals VLED, CH1, CH2, CH3, CH4, ---. Likewise, the connector C1 has terminals VLED, CH1, CH2, CH3, CH4, ---. In addition, the FFC 60 has transmission lines 60a, 60b, 60c, 60d, 60e, ---, based on the number of the terminals of the connectors C1 and C2.

The connector C1 and the connector C2 are connected by the following relation. At first, the terminal VLED of the connector C2 is connected to the terminal VLED of the connector C1 via the transmission line 60a. The terminal VLED of the connector C1 is connected to anode sides of LED bars 40a, 40b, 40c, ---. On the other hand, cathode sides of LED bars 40a, 40b, 40c, --- are connected to respective terminals of the connector C1. For example, a cathode side of the LED bar 40a is connected to the terminal CH1 of the connector C1, a cathode side of the LED bar 40b is connected to the terminal CH2 of the connector C1, a cathode side of the LED bar 40c is connected to the terminal CH3 of the connector C1, and a cathode side of the LED bar 40d is connected to the terminal CH4 of the connector C1. The terminals CH2, CH2, CH3, CH4, --- of the connector C1 are connected respectively to the terminals CH1, CH2, CH3, CH4, --- of the connector C2 via the transmission lines 60b, 60c, 60d, 60e, ---. The terminals CH1, CH2, CH3, CH4, --- of the connector C2 are connected to the ground, and the connection to the ground can be switched by switching circuits S1, S2, S3, S4, --- (e.g. FET). The switching circuits S1, S2, S3, S4, --- are installed on the LED driver circuit 50, and the LED driver circuit 50 can control switching of the switching circuits S1, S2, S3, S4, ---.

As to the connectors C1 and C2 connected as explained above, the LED driver circuit 50 applies a power supply voltage on the terminal VLED of the connector C2 to turn on the LED bars 40. Therefore, if the switching circuits S1, S2, S3, S4, --- are turned on, the power supply voltage input to the terminal VLED of the connector C2 is applied to the LED bars 40a, 40b, 40c, 40d, --- and the LED bars 40a, 40b, 40c, 40d, --- are turned on. On the other hand, if the switching circuits S1, S2, S3, S4, --- are turned off, the power supply voltage input to the terminal VLED of the connector C2 is not applied to the LED bars 40a, 40b, 40c, 40d, --- and the LED bars 40a, 40b, 40c, 40d, --- are turned off. In other words, the LED driver circuit 50 can control to turn on/off the LED bars 40a, 40b, 40c, ---. Furthermore, the control section 10, which controls the LED driver circuit 50, can control to turn on/of them.

As explained above, the power supply voltage to be supplied to the LED bars 40 is generated and whether or not to supply power to each of the LED bars is controlled at a side of the LED driver circuit board B2, and the generated power supply voltage is transferred to the LED board B1 via the FFC 60.
Here, when assembling the liquid crystal display device 100, both ends of the FFC 60 are inserted to the connectors C1 and C2 by workers. If the FFC 60 is abnormally connected when assembling, power is not normally supplied to the LED bars 40 and the LED bars 40 may be broken, other parts may be broken, or the liquid crystal display device 100 may be abnormally operated.

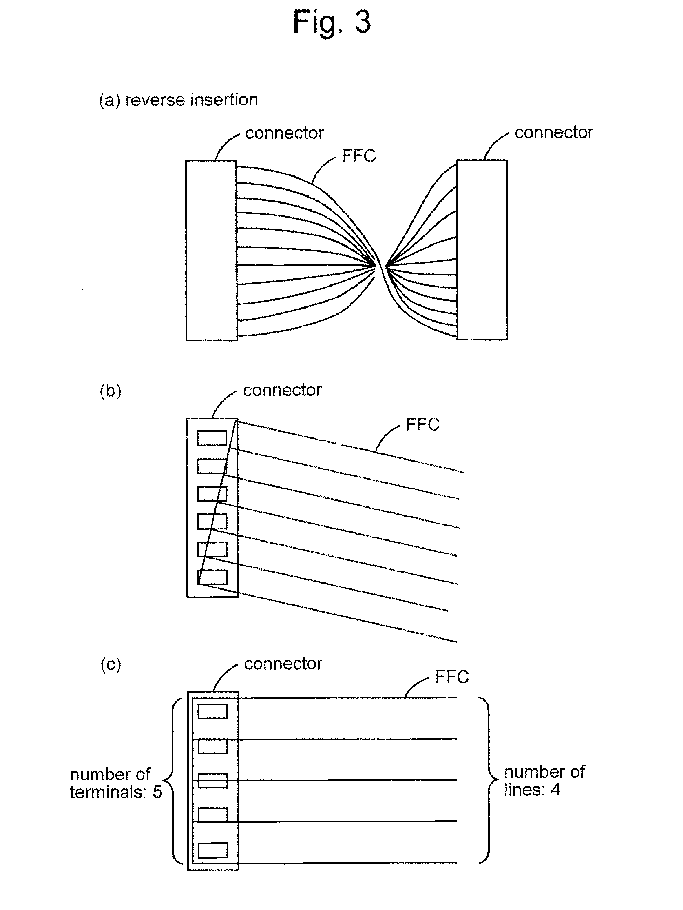

Fig. 3 shows abnormal connections of the FFC 60.
(a) of the figure shows a situation where the FFC 60 is reversely inserted. If the FFC 60 is reversely inserted, the terminals of the FFC 60 are connected to originally unintended terminals. Therefore, abnormal voltage can be provided to elements of the circuits with high possibility.
(b) of the figure shows a situation where the FFC 60 is obliquely inserted. If the FFC 60 is obliquely inserted, some terminals are connected while other terminals are not connected. Therefore, abnormal voltage can be provided to elements of the circuits. In addition, if the FFC 60 is obliquely inserted, terminals can short out. Also in this case, abnormal voltage can be provided.
(c) of the figure shows a situation where an incorrect FFC is connected. In this case, electrical continuity may not be established at all because of difference of the number of the terminals, but electrical continuity may be insufficiently established in some cases. Therefore, abnormal voltage can be provided to elements of the circuits.
The abnormal connections except for (c) of the figure can happen anytime from when assembling a product until when the product is used by users, while the abnormal connection shown in (c) of the figure can happen when assembling the product. In the present embodiment, the abnormal connections can be quickly found by executing the later explained abnormal connection detection process using the following abnormal connection detection circuit.

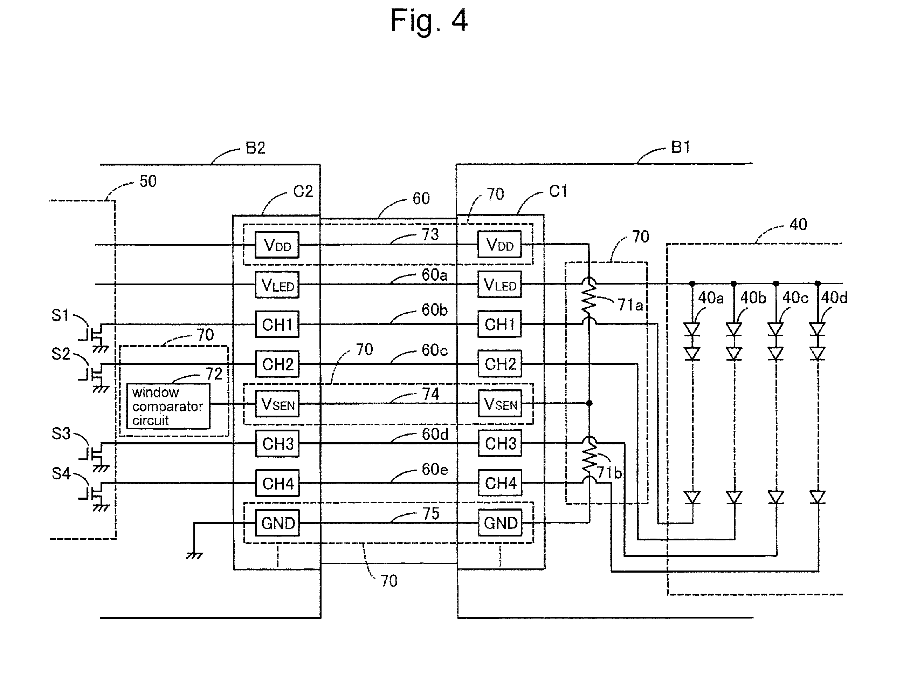

Here, with reference to Fig. 4, a structure of an abnormal connection detection circuit to detect the abnormal connection of the FFC 60 will be explained. As shown in the figure, the abnormal connection detection circuit 70 has a resistor 71 a and a resistor 71b that are mounted on the LED board B1, and a window comparator circuit 72 that is mounted on the LED driver circuit board B2. In addition, the abnormal connection detection circuit 70 uses three transmission lines 73, 74 and 75 of the FFC 60. Note that in case the three transmission lines 73, 74 and 75 overlap with the transmission lines 60a, 60b, 60c, 60d, 60e, --- shown in Fig. 2, the transmission lines 60a, 60b, 60c, 60d, 60e,shown in Fig. 2 should be displaced adequately.

Here, relations of connection of the LED driver board side will be explained. Terminals VDD, VSEN and GND are provided on the connectors C1 and C2. Constant voltage is supplied to the terminal VDD of the connector C2. The terminal VSEN of the connector C2 is connected to the window comparator circuit 72. The terminal GND of the connector C2 is connected to the ground. The terminals VDD, VSEN and GND are connected respectively to the transmission lines 73, 74 and 75, and connected respectively to the terminal VDD, VSEN and GND of the connector C2 via the transmission lines 73, 74 and 75.

Note that the terminal VDD can be commonalized with the terminal LED. In such a case, the terminal VDD (and the transmission line 73) are not provided and the terminal VLED (and the transmission line 60a) are used as a substitute for the terminal VDD.

The window comparator circuit 72 connected to the terminal VSEN judges whether or not a voltage of the terminals VSEN of the connector C2 is within a predetermined range, and outputs a result of the judgment to the control section 10.

Next, relations of connection of the LED board side will be explained. The terminal VDD of the connector C1 is connected to one end of the resistor 71a, and the terminal GND of the connector C1 is connected to one end of the resistor 71b. Another end of the resistor 71 a (the end not connected to the connector C2) and another end of the resistor 71b (the end not connected to the connector C2) are connected with each other, and they are corresponding to the voltage dividing resistor in the present embodiment. A connection point between the resistor 71a and the resistor 71b (a dividing point of the voltage dividing resistor) is connected to the terminal VSEN of the connector C1. Note that the resistor 71a is corresponding to the first resistor and the resistor 71b is corresponding to the second resistor in the present embodiment.

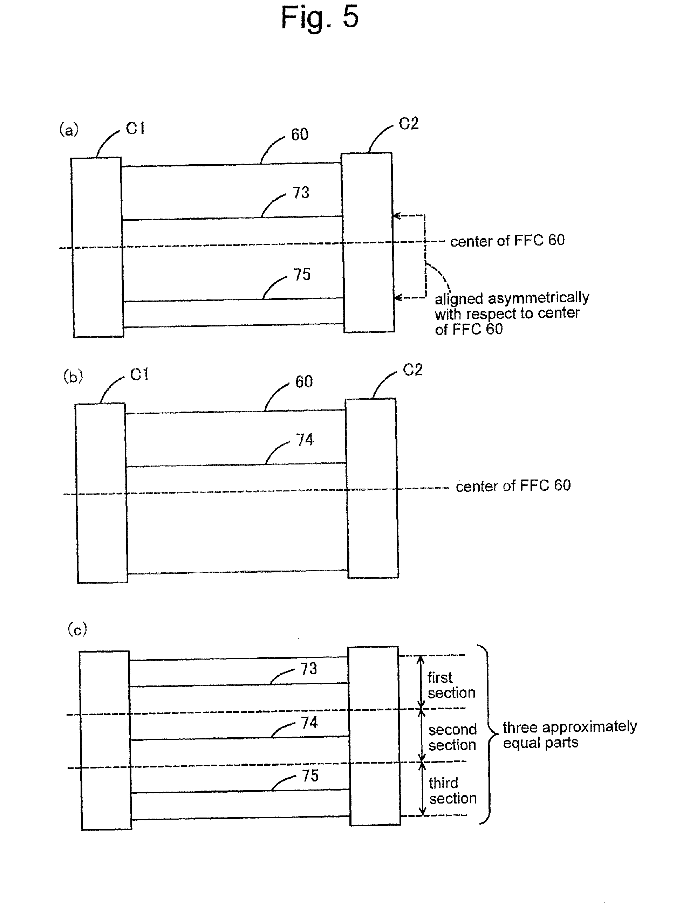

The transmission lines 73, 74 and 75 to connect between the connectors C1 and C2 as explained above can be variously aligned on the FFC 60, but a basic principle will be explained below.
(a) to (c) of Fig. 5 show alignments of transmission lines 73, 74 and 75. Note that only one of (a) to (c) of Fig. 5 can be applied separately or any of them can be applied in combination.

(a) of the figure shows a positional relation between the transmission lines 73 and 75. In the figure, the transmission lines 73 and 75 are aligned asymmetrically with respect to the center of the FFC 60. In this state, if the FFC 60 is reversely inserted, for example, the loop circuit is not realized by the transmission lines 73, 75, the resistor 71a and the resistor 71b (between the constant voltage applied to the terminal VDD of the connector C2 and the ground connected to the terminal GND). Therefore, the proper voltage is not generated at the dividing point of the voltage dividing resistor. Consequently, an abnormal voltage, which is different from the voltage generated when the FFC 60 is normally connected, is generated at the terminal VSEN of the connector C2. By specifying a threshold value of the window comparator circuit 72 appropriately to distinguish the abnormal voltage with the proper voltage, the control section 10 can detect the reverse insertion of the FFC 60 based on the output of the window comparator circuit 72. Of course, in case the FFC 60 is obliquely inserted, the abnormal connection can also be detected. The threshold value of the window comparator circuit 72 is specified in an appropriate range in consideration of an acceptable error of the resistor 71a and the resistor 71b and an acceptable error of the constant voltage input via the terminal VDD. Note that the transmission line 73 is corresponding to the first transmission line and the transmission line 75 is corresponding to the second transmission line in the present embodiment.

(b) of Fig. 5 shows an alignment of the transmission line 74. In the figure, the transmission line 74 of the FFC 60 is configured not to pass through approximately center of the FFC 60. By using the above mentioned structure, if the FFC 60 is reversely inserted, for example, the transmission line 74 is not connected to the terminal VSEN of the connector C2, and the voltage of the dividing point of the voltage dividing resistor can not be detected. Therefore, the abnormal voltage is generated at the terminal VSEN of the connector C2. In this state, by specifying the threshold value of the window comparator circuit 72 appropriately to distinguish the abnormal voltage with the proper voltage, the control section 10 can detect the reverse insertion of the FFC 60 based on the output of the window comparator circuit 72. Of course, in case the FFC 60 is obliquely inserted, the abnormal connection can also be detected. Note that the transmission line 74 is corresponding to the third transmission line in the present embodiment.

(c) of Fig. 5 shows positional relation among the transmission lines 73, 74 and 75. In the figure, when plural transmission lines of the FFC 60 are divided into three approximately equal parts of two end parts and a middle part (a first section, a second section and a third section in the figure), the first transmission line 73 is aligned on the first section that is located at one of the ends, the second transmission line 75 is aligned on the third section that is located at another end, and the third transmission line 74 is aligned on the second section that is located at approximately center. By using the above mentioned structure, the transmission lines 73 to 75 are aligned all around the FFC 60 and the connection state of the FFC 60 can be reliably detected even when the FFC 60 is obliquely inserted causing connection errors in certain parts while other parts are normally connected.

Note that any two of the transmission lines 73, 74 and 75 can be aligned on the ends of the FFC 60. By locating the transmission lines as explained above, the transmission lines 73, 74 and 75 are aligned all around the FFC 60. Therefore, the oblique insertion can be detected reliably.

In addition to any one of the structures shown in Figs. 5(a) to (c) or combination of them, resistance values of the resistor 71a and the resistor 71b can be made to be different. By using the above mentioned structure, if the FFC 60 is reversely inserted, for example, the voltage, which is different from the voltage when the FFC 60 is normally connected, is generated at the terminal VSEN of the connector C2. Therefore, by specifying the threshold value of the window comparator circuit 72 appropriately, the control section 10 can detect the reverse insertion of the FFC 60 based on the output of the window comparator circuit 72. Of course, in case the FFC 60 is obliquely inserted, the abnormal connection can also be detected.

### (3) Abnormal connection detection process:

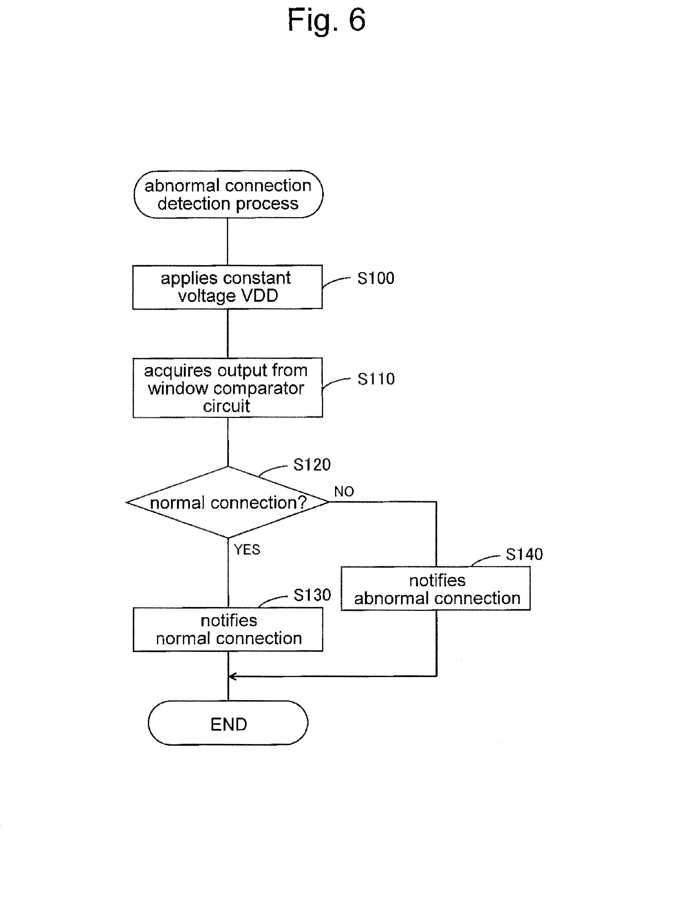

Next, an abnormal connection detection process will be explained with reference to Fig. 6. In the figure, an abnormal connection detection process is shown as a flow chart. This process is executed by the control section 10 when the liquid crystal display devise 100 is turned on while inputting a predetermined operation (e.g. input of hidden command) from a not illustrated operation input section in an inspection process after the liquid crystal display devise 100 is assembled or an inspection process when repairing the liquid crystal display devise 100. Of course, the process can be executed before supplying power to the LED bars 40 when instructed to turn on the LED bars after the liquid crystal display devise 100 is turned on.

Once the process is started, the control section 10 controls the LED driver circuit 50 preventing the LED driver circuit 50 from supplying power to the LED bars 40, and applies the constant voltage to the terminal VDD of the connector C2 (S100). Then, the constant voltage is applied to a channel formed by the terminal VDD of the connector C2, the transmission line 73, the terminal VDD of the connector C1, the resistor 71a, the resistor 71b, the terminal GND of the connector C1, the transmission line 75, and the terminal GND of the connector C2. Therefore, if the FFC 60 is connected normally, a predetermined voltage specified according to the resistance values of the resistor 71a and 71 b is generated at the dividing point between the resistor 71a and 71b, and the generated voltage is input to the window comparator circuit 72 via the terminal VSEN of the connector C1, the transmission line 74, and the terminal VSEN of the connector C2. The window comparator circuit 72 compares the input voltage with two upper and lower threshold values. If the input voltage is between the two upper and lower threshold values, the window comparator circuit 72 outputs a voltage signal indicating the normal connection to the control section 10. On the other hand, if the input voltage is not between the two upper and lower threshold values, the window comparator circuit 72 outputs a voltage signal indicating the abnormal connection to the control section 10.

The control section 10 acquires the voltage signal output from the window comparator circuit 72 (S 110). Then, the control section 10 judges whether or not the connection of the FFC 60 is normal based on the voltage signal (S120). If the voltage signal indicates the normal connection (S120: Yes), the control section 10 controls the OSD section 21 of the image processing section 20 to display a message indicating the normal connection of the FFC 60 on the screen of the image display section 30 (S130). Then, the worker finishes inspecting the connection of the FFC 60 after checking the message.
On the other hand, if the voltage signal indicates the abnormal connection (S120: No), the control section 10 controls the OSD section 21 of the image processing section 20 to display a message indicating the abnormal connection of the FFC 60 on the screen of the image display section 30 (S 140). Then, the worker confirms and fixes the connection of the FFC 60, and then the abnormal connection detection process is executed again. The worker repeats the abnormal connection detection process and the fixing of the connection of the FFC 60 until the message indicating the normal connection is displayed on the screen.

By using the above explained abnormal connection detection process, the connection state of the FFC 60 can be notified to those who concerning the liquid crystal display device 100 such as the workers assembling the liquid crystal display device 100, the workers repairing and maintaining the liquid crystal display device 100, or users of the liquid crystal display device 100. Therefore, usability, workability, ease of maintenance, or the like can be improved. Note that the OSD section 21 and the image display section 30 that display the connection state of the FFC 60 under the control of the control section 10 are corresponding to the notice section in the present embodiment. In addition, the state is notified to the worker by using the image display section 30 or the like in the present embodiment, but it can be notified by using such as a lighting of LEDs, a stand-alone display, a sound output from a not illustrated speaker, or the like.

### (4) General overview and variation examples:

As explained above, in the liquid crystal display devise of the above described embodiment, when the LED board B1 and the LED driver circuit board B2 are connected via the FFC (Flexible Flat Cable) 60, the voltage dividing resistor is formed by the resistors 71a and 71b mounted on the LED board B1, the connection detection section is connected to one end of the voltage dividing resistor via the transmission line 73 of the FFC 60, connected to another end of the voltage dividing resistor via the transmission line 75 of the FFC 60, and connected to the dividing point of the voltage dividing resistor via a third transmission line 74 of the FFC 60, wherein at least one of the following compositions are applied: (1) the transmission line 74 is configured not to pass through a center of the FFC 60, and (2) the resistance values of the resistor 71 a and the resistor 71b are made to be different. Then, the control section 10 is configured to detect the connection state of the FFC 60 based on the voltage of the dividing point detected via the transmission line 74 by supplying power to the loop circuit that is composed of the transmission line 73, the voltage dividing resistor and the transmission line 75. By using the above mentioned structure, the cable connection errors such as the reverse insertion and the oblique insertion can be detected more reliably.

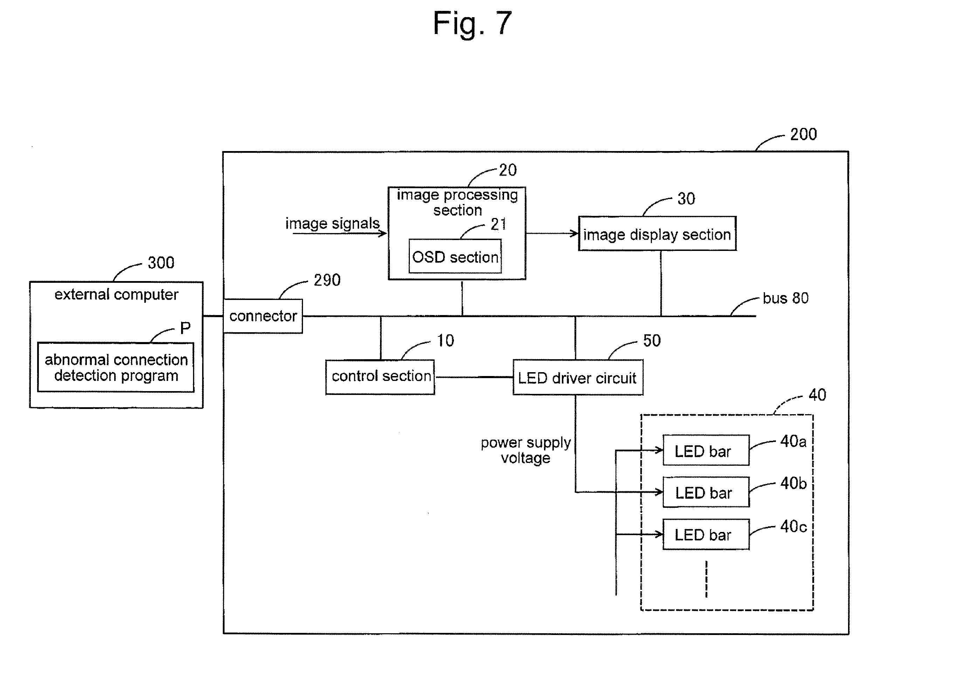

Fig. 7 is a block diagram showing a structure of an inspection system of a liquid crystal display device 200 concerning a variation example. As shown in the figure, the liquid crystal display device 200 has the same structure as the above explained liquid crystal display device 100. (However, the OSD section is not necessary for the liquid crystal display device 200.) In Fig. 7, same symbols are assigned to the components that are in common with Fig. 1. The liquid crystal display device 200 has a bus 80 (e.g. I2C (Inter IC) bus) in addition to the components of Fig. 1, and the components are connected by the bus 80 to communicate with each other.

A connector 290 is connected to the bus 80 to connect a predetermined jig. By connecting an external computer 300 to the connector 290 via a predetermined cable, the liquid crystal display device 200 can be controlled from the external computer 300. In this variation example, by controlling the control section 10 from the external computer 300, the connection state of the FFC 60 that connects the LED driver circuit board B2 and LED board B1 of the liquid crystal display device 200 can be inspected.

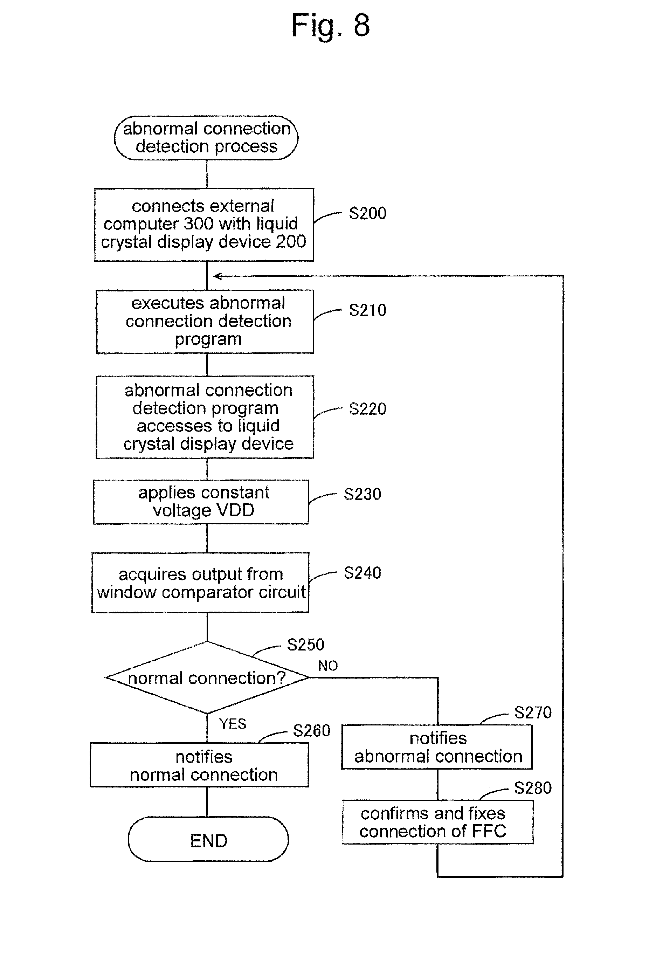

Fig. 8 is a flow chart showing an abnormal connection detection process executed by the worker using the external computer. The worker connects the external computer 300 with the liquid crystal display device 200 by using the predetermined cable (S200). Then, an abnormal connection detection program P is executed on the external computer 300 by inputting a predetermined operation from an operation input section such as a key board or a mouse of the external computer 300 (S210). Consequently, the abnormal connection detection program P accesses to the bus 80 via the predetermined cable, and controls the liquid crystal display device 200 (S220).

The abnormal connection detection program P prevents the LED driver circuit 50 from supplying power to the LED bars 40, and applies the constant voltage to the terminal VDD of the connector C2 (S230). Consequently, the constant voltage is applied to a channel formed by the terminal VDD of the connector C2, the transmission line 73, the terminal VDD of the connector C1, the resistor 71a, the resistor 71b, the terminal GND of the connector C1, the transmission line 75, and the terminal GND of the connector C2. Therefore, if the FFC 60 is connected normally, a voltage specified according to the resistance values of the resistor 71a and 71b is generated at the dividing point between the resistor 71 a and 71b, and the generated voltage is input to the window comparator circuit 72 via the terminal VSEN of the connector C1, the transmission line 74, and the terminal VSEN of the connector C2. The window comparator circuit 72 compares the input voltage with two upper and lower threshold values. If the input voltage is between the two upper and lower threshold values, the window comparator circuit 72 outputs a voltage signal indicating the normal connection to the external computer 300 via the bus 80. On the other hand, if the input voltage is not between the two upper and lower threshold values, the window comparator circuit 72 outputs a voltage signal indicating the abnormal connection to the external computer 300 via the bus 80.

The abnormal connection detection program P acquires the voltage signal output from the window comparator circuit 72 (S240). Then, the abnormal connection detection program P judges whether or not the normal connection of the FFC 60 based on the voltage signal (S250). If the voltage signal indicates the normal connection (S250: Yes), the external computer 300 display a message indicating the normal connection of the FFC 60 on its screen (S260). Then, the worker finishes inspecting the connection of the FFC 60 after checking the message.
On the other hand, if the voltage signal indicates the abnormal connection (S250: No), the external computer 300 display a message indicating the abnormal connection of the FFC 60 on its screen (S270). Then, the worker confirms and fixes the connection of the FFC 60 (S280), and then the abnormal connection detection process is executed again. The worker repeats the abnormal connection detection process and the fixing of the connection of the FFC 60 until the message indicating the normal connection is displayed on the screen.
As explained above, the present invention can be also achieved as an inspection system having the same effect as the above described embodiment.

Note that, this invention is not limited to the above-mentioned embodiments. Although it is to those skilled in the art, the following are disclosed as the one embodiment of this invention.
- Mutually substitutable members, configurations, etc. disclosed in the embodiment can be used with their combination altered appropriately.
- Although not disclosed in the embodiment, members, configurations, etc. that belong to the known technology and can be substituted with the members, the configurations, etc. disclosed in the embodiment can be appropriately substituted or are used by altering their combination.
- Although not disclosed in the embodiment, members, configurations, etc. that those skilled in the art can consider as substitutions of the members, the configurations, etc. disclosed in the embodiment are substituted with the above mentioned appropriately or are used by altering its combination.

### [Description of the Reference Numerals]

10: control section, 20: image processing section, 21: OSD section,
30: image display section, 40: LED bars, 40a to 40d: LED bars, 50: LED driver circuit,
60a to 60e: transmission lines, 70: abnormal connection detection circuit,
71a: first resistor, 71b:second resistor, 72: window comparator circuit,
73: first transmission line, 74: third transmission line, 75: second transmission line,
80: bus, 100: liquid crystal display device, 200: liquid crystal display device,
290: connector, 300: external computer, B1: LED board, B2: LED driver circuit board,
C1: connector, C2: connector, CH1: terminal, CH2: terminal, CH3: terminal,
CH4: terminal, GND: terminal, P: abnormal connection detection program,
S1: switching circuit, S2: switching circuit, S3; switching circuit, S4: switching circuit,
VDD: terminal, VLED: terminal, VSEN: terminal

## Claims

1. An LED (Light-Emitting diode) lighting device in which an LED board that mounts LEDs and an LED driver board that forms an LED driver circuit to turn on the LEDs are connected by an FFC (Flexible Flat Cable), comprising:
a voltage dividing resistor that has a first resistor and a second resistor and mounted on the LED board, and
a connection detection section that is connected to one end of the voltage dividing resistor via a first transmission line of the FFC, connected to another end of the voltage dividing resistor via a second transmission line of the FFC, and connected to a dividing point of the voltage dividing resistor via a third transmission line of the FFC, supplies power to a loop circuit composed of the first transmission line, the voltage dividing resistor and the second transmission line, and detects a connection state of the FFC based on a voltage of the dividing point detected via the third transmission line, wherein
at least one of the following compositions are applied: (1) the third transmission line of the FFC is configured not to pass through a center of the FFC, and (2) the resistance values of the first resistor and the second resistor are made to be different.

2. The LED lighting device according to claim 1, wherein
the first transmission line and the second transmission line are located asymmetrically with respect to the center of the FFC.

3. The LED lighting device according to claims 1 or 2, wherein
the connection detection section has a notice section that notifies the connection state of the FFC.

4. The LED lighting device according to any one of claims 1 to 3, wherein
the connection detection section detects that the FFC is normally connected if the voltage of the dividing point is within a predetermined range white the connection detection section detects that the FFC is abnormally connected if the voltage of the dividing point is out of the predetermined range.

5. The LED lighting device according to any one of claims 1 to 4, wherein
the connection detection section has a window comparator circuit, and
the connection of the FFC is detected to be normal if the window comparator circuit judges the voltage of the dividing point is within a predetermined range while the connection is detected to be abnormal if the window comparator circuit judges the voltage of the dividing point is out of the predetermined range.

6. The LED lighting device according to any one of claims 1 to 5, wherein
when plural transmission lines of the FFC are divided into two end parts and a middle part, the first transmission line, the second transmission line and the third transmission line are configured to be included one by one in each part.

7. The LED lighting device according to any one of claims 1 to 6, wherein
an LED bar is formed by connecting plural LEDs in series,
an LED circuit is formed by connecting plural LED bars in parallel,
the LED circuit is mounted on the LED board, and
the LED driver circuit supplies a predetermined power to respective LED bars via the FFC.

8. The LED lighting device according to claim 1, wherein
the LED lighting device is a back light device to emit light from a back side of a liquid crystal panel of the liquid crystal display devise or a side light device to emit light from a lateral side of the liquid crystal panel of the liquid crystal display devise,
an LED bar is formed by connecting plural LEDs in series,
an LED circuit is formed by connecting plural LED bars in parallel,
the LED circuit is mounted on the LED board,
the LED driver circuit supplies a predetermined power to respective LED bars via the FFC,
the connection detection section has a window comparator circuit,
the connection of the FFC is detected to be normal if the window comparator circuit judges the voltage of the dividing point is within a predetermined range while the connection is detected to be abnormal if the window comparator circuit judges the voltage of the dividing point is out of the predetermined range, and
when plural transmission lines of the FFC are divided into two end parts and a middle part, the first transmission line is located on one of the end parts, the second transmission line is located on another end part, and the third transmission line is located on the middle part.

9. A cable connection detection device in which a first board and a second board are electrically connected by an FFC (Flexible Flat Cable), comprising:
a voltage dividing resistor that has a first resistor and a second resistor and mounted on the first board, and
a connection detection section that is connected to one end of the voltage dividing resistor via a first transmission line of the FFC, connected to another end of the voltage dividing resistor via a second transmission line of the FFC, and connected to a dividing point of the voltage dividing resistor via a third transmission line of the FFC, supplies power to a loop circuit that is composed of the first transmission line, the voltage dividing resistor and the second transmission line, and detects a connection state of the FFC based on a voltage of the dividing point detected via the third transmission line, wherein
at least one of the following compositions are applied: (1) the third transmission line of the FFC is configured not to pass through a center of the FFC, and (2) the resistance values of the first resistor and the second resistor are made to be different.
